# Europäisches Patentamt

# European Patent Office

# Office européen des brevets

(19)

(11) Veröffentlichungsnummer : **0 282 540 B1**

(12)

# EUROPÄISCHE PATENTSCHRIFT

(45) Veröffentlichungstag der Patentschrift :
04.03.92 Patentblatt 92/10

(51) Int. Cl.$^5$ : **C23C 14/28, C23C 14/56**

(21) Anmeldenummer : **87906068.9**

(22) Anmeldetag : **16.09.87**

(86) Internationale Anmeldenummer :
**PCT/DE87/00419**

(87) Internationale Veröffentlichungsnummer :
**WO 88/02034 24.03.88 Gazette 88/07**

(54) **VERFAHREN UND VORRICHTUNG ZUM METALLISIEREN VON FOLIENOBERFLÄCHEN.**

(30) Priorität : **20.09.86 DE 3632027**

(43) Veröffentlichungstag der Anmeldung :
**21.09.88 Patentblatt 88/38**

(45) Bekanntmachung des Hinweises auf die
Patenterteilung :
**04.03.92 Patentblatt 92/10**

(84) Benannte Vertragsstaaten :
**AT BE CH DE FR GB IT LI LU NL SE**

(56) Entgegenhaltungen :
**DD-B- 206 499
FR-A- 1 445 545
US-A- 3 350 219
Patent Abstracts of Japan, vol.8, no. 126,
(C-228) (1563), 13 June 1984**

(73) Patentinhaber : **de Rudnay, André, Dr.
16 Chemin de Renens Château de Valency
CH-1004 Lausanne (CH)**

(72) Erfinder : **de Rudnay, André, Dr.
16 Chemin de Renens Château de Valency
CH-1004 Lausanne (CH)**

(74) Vertreter : **Michelis, Theodor, Dipl.-Ing. et al
Seibert + Michelis Rechtsanwälte und
Patentanwälte Tattenbachstrasse 9
W-8000 München 22 (DE)**

EP 0 282 540 B1

## Beschreibung

Die Erfindung bezieht sich auf ein Verfahren zum Metallisieren von Folienoberflächen mit einem reaktiven Metall gemäß dem Oberbegriff des Patentanspruches 1 sowie auf einen Verdampfer für eine Bandbedampfungsanlage gemäß dem Oberbegriff des Patentanspruches 4 zur Durchführung des vorgenannten Verfahrens.

Es ist bekannt, Kunststoffolien im Vakuum zu metallisieren. Wie unter anderem von Heinz Walter in dem Buch "Veredeln von Kunststoff-Oberflächen" auf Seite 107-134, Carl Hanser Verlag, München-Wien 1974 beschrieben, werden zum Verdampfen des aufzudampfenden Materials, also beispielsweise Aluminium, z.B. durch direkten Stromdurchgang widerstandsbeheizte sinterkeramische Verdampfer eingesetzt. Diese Art der Verdampfung muß aber auf eine Reihe von Vorteilen verzichten, die anderen Aufdampfverfahren eigen sind. So kann an den widerstandsbeheizten sinterkeramischen Verdampfern die beim Bedampfen von Kondensatorfolien erwünschte, z.B. bei indirekt beheizten Zinkverdampfern stets eingesetzte Maskenabdeckung, vgl. Abbildung 5.11 des vorgenannten Buches nicht angebracht werden. Im Gegensatz zu anderen Verdampfern sind bei den sinterkeramischen Verdampfern keine Ausführungen verfügbar, die lang genug sind, um eine ganze Folienbreite einer modernen Bedampfungsanlage zu metallisieren. Es müssen deshalb mehrere, einzeln geregelte sinterkeramische Verdampfer eingesetzt werden. Dabei kann die an sich unter Anwendung einer Kathodenzerstäubung erzielbare Schichtdickentoleranz von nur 2% nicht eingehalten werden. Ein Aufdampfen kann nur von unten nach oben und nicht auch nach der Seite hin erfolgen. Weiter beträgt der Wirkungsgrad des verdampften Aluminiums (Verhältnis des aufgedampften Gutes zu verdampften Gut) nur rund 30%. Eine automatische Regelung der Schichtstärke ist nur mit großem Aufwand möglich.

Da darüberhinaus die Aufdampftemperatur im Dauerbetrieb höchstens 1500°C betragen darf, weisen die einzelnen Metallatome nur 0,15 eV auf, wobei diese geringe Energie in Folge der isentropen Expansion des Dampfes noch vor dem Aufkondensieren auf einige hundertstel eV gesenkt wird, was dazu führt, daß die aufkondensierte Metallschicht nur eine relativ geringe Haftfestigkeit und auch nicht die Dichte erreicht, die beispielsweise mit Hilfe eines Elektronenstrahlverdampfers in Verbindung mit ion plating aufgrund des um mehrere Zehnerpotenzen höheren Energieinhaltes der aufkondensierten Metallatome erzielt wird. Dabei kann die an sich nicht mögliche Maskenabdeckung durch aufwendige Mittel, beispielsweise umlaufende Maskenbänder, wie in Abbildung 5.23 des vorgenannten Buches gezeigt, ersetzt werden, ohne daß jedoch die gleichfalls erwünschte Funktion der Maskenabdeckung von Zinkverdampfern, nämlich die Verstärkung des metallischen Randes einer Kondensatorfolie, möglich würde.

Zum Verdampfen von Metallen sind schon verschiedene Verfahren entwickelt worden. So zeigt beispielsweise die japanische Patentanmeldung 57-146907, publiziert in Patent Abstract of Japan, Band 8, Nr. 126, (C-228) (1563), 13. Juni 1984; & JP-A-5938381 eine Vakuumbedampfungsanlage zum Beschichten eines Stahlbandes mit Zink. Die dort vorgeschlagene Anlage besteht aus einem Verdampfer, mit einer auf das zu bedampfende Band gerichteten Öffnung und einer im Inneren des Verdampfers montierten Strahlungsheizung, die das dort befindliche verflüssigte Zink nicht berührt. Das geschmolzene Zink wird dem Verdampfer aus einem Schmelzofen mit Überdruck zugeführt. Eine derartige Arbeitsweise ist zum Aufdampfen eines reaktiven Materials, wie Al oder dgl. schon wegen der sehr viel höheren Verdampfungstemperaturen nicht möglich. Es sind auch schon Verfahren entwickelt worden, bei denen das zu verdampfende Metall in der Flüssigphase über die Oberfläche eines porösen Körpers unter Ausnutzung des Kriecheffektes geführt und dort einer weiteren Wärmezufuhr ausgesetzt wird. Derartige Verfahren sind u.a. der DE-OS 3 239 131, DE-OS 1 908 669, DE-PS 843 787, DE-PS 812 025 oder US-PS 2 665 225 zu entnehmen.

Mit dieser Art der Wärmezufuhr kann dem Metalldampf weder eine Richtung noch - und das ist von besonderer Wichtigkeit - weitere Energie in Form thermisch erzeugter Photonen zugeführt werden.

Die FR-PS 1 445 545 zeigt für einen konkreten, aber nicht im einzelnen beschriebenen Zweck, jedenfalls nicht für eine Bandbedampfungsanlage, wie Metall innerhalb eines hohlkörperförmigen Strahlungsheizkörpers verdampft werden kann. Dabei wird das zu verdampfende reaktive Metall in Drahtform der Oberfläche eines z.B. aus $TiB_2$ bestehenden "entfernbaren Stöpsels" zugeführt und von diesem verdampft.

Auch bei einer derartigen Ausführungsform sind die in Verbindung mit sinterkeramischen Verdampfern genannten Nachteile hinsichtlich Ausrichtung des Metalldampfes und der Energiezufuhr gegeben, abgesehen davon, daß Strahlungsheizkörper und Aufnahmestöpsel für das flüssige Metall nicht in einer für eine Bandbedampfungsanlage notwendigen Größe gebaut werden könnten.

Aufgabe der Erfindung ist es, ein Verfahren und einen Verdampfer zur Durchführung des Verfahrens anzugeben, bei dem in einfacher Weise dem reaktiven Aufdampfgut auch in seiner Dampfphase eine gegenüber herkömmlichen Verfahren sehr viel höhere kinetische Energie aufprägbar ist, indem bei erhöhter Lebensdauer von Verdampfer und Heizeinrichtung selbst dem Metalldampf eine sehr viel höhere Temperatur gegeben wird.

Diese Aufgabe wird mit einem Verfahren zum Metallisieren mit den Merkmalen des Patentanspruches 1 gelöst.

2

Ein Verdampfer zur Durchführung dieses Verfahrens ist Gegenstand des Patentanspruches 4. Vorteilhafte Weiterbildungen ergeben sich hinsichtlich des Verfahrens aus den Patentansprüchen 2 und 3 und hinsichtlich des Verdampfers aus den Unteransprüchen 5 bis 8.

Bei dem Verfahren nach der Erfindung wird also der Verdampfer selbst als Hohlkörper mit einer vorzugsweise schlitzförmigen Austrittsöffnung ausgeführt, wobei das vorverflüssigte Metall auf der Innenseite verteilt geführt wird und dort thermisch erzeugten Photonen ausgesetzt wird, die von einem im Abstand von der Wandung und damit auch im Abstand von dem vorverflüssigten Metall angeordneten Strahlungsheizkörper abgestrahlt werden. Dabei wird, um ständig ausreichend vorverflüssigtes Verdampfungsmaterial verdampfen zu können, die Innenwandung des Hohlkörpers in an sich von den vorbekannten Verdampfungsanlagen bekannter Weise porös gehalten, so daß das flüssige Metall sich gleichmäßig über die Oberfläche verteilt oder aus dieser heraustritt und nicht etwa abtropft sondern im Gegenteil sogar bei einigen Ausführungsformen nach oben steigt.

Die Wandung eines derartigen zum Hohlkörper geformten Verdampfers hat keinerlei Heizungsfunktion für das zu verdampfende Gut, so daß die thermische Beanspruchung und damit auch die Beanspruchung durch das reaktive Metall im Vergleich zu den anderen Verdampfern wesentlich geringer ist.

Außerdem wirkt der Hohlkörper gleichzeitig als thermische Abschirmung, was sich günstig auf den Energiebedarf auswirkt, da die Abstrahlung von Wärme nach außen stark reduziert wird.

Der Strahlungsheizkörper, mit dessen Hilfe das zu verdampfende Gut sowohl in der Flüssigphase als auch in der Dampfphase zusätzlich mit Strahlungsenergie (Photonen) beaufschlagt wird, kommt mit dem flüssigen Verdampfungsgut nicht in Berührung und da dessen hohe Temperatur keine stabile Legierungsbildung mehr zuläßt, kommen auch zwischen dem Material des Strahlungsheizkörpers und dem zu verdampften Metall keinerlei Reaktion zustande.

Die Energie des Dampfes wird aber durch Kontakt mit dem viel heißeren, vorzugsweise auf mindestens 2500°C oder mehr erwärmten Strahlungsheizkörper sowie mit den von ihm emittierten Elektronen erhöht. Dabei wird auch ein Teil des Dampfes ionisiert, so daß durch Anlegen eines elektrischen Feldes der Energieinhalt weiter gesteigert werden kann. Nicht aktiv an der Verdampfung mitwirkende Teile des Verdampfers können mit pyrolitisch abgeschiedenem BN dünn beschichtet oder auf beliebige andere Weise benetzungsabweisend behandelt werden, damit das verflüssigte Metall diese Teile nicht bedeckt und sie bei Bedarf auch mit einer Wärmeisolierung oder einem Strahlungsschutz versehen werden können.

Der auf der Innenseite, vorzugsweise mit Kapillaren versehene Hohlkörper kann zur besseren Absorption der Strahlungswärme aus einem grauen oder dunklen Körper hergestellt oder mit einem diese gut absorbierenden Belag bedeckt werden. Die Kapillaren können dabei gemäß einer vorteilhaften Weiterbildung des Erfindungsgedankens so gestaltet werden, daß ihr Durchmesser sich schichtenweise verändert, wobei der kleinste Durchmesser auf der inneren Oberfläche des Verdampfers oder auf Teilen davon angeordnet ist.

Durch die Ausbildung der Kapillaren können neue Benetzungs- und Saugeffekte erzielt werden, die die Leistungsfähigkeit und Vielfältigkeit des Verfahrens nach der Erfindung zu steigern in der Lage sind. Wie bei einem Zinkverdampfer kann der Verdampfer auch eine beliebige, insbesondere auch austauschbare Maskenabdeckung erhalten. Im Gegensatz zu einem Zinkverdampfer kann aber der als Hohlkörper ausgebildete Verdampfer für die Zwecke der Erfindung nicht nur aus einem einzigen, sondern auch aus mehreren kürzeren aber zusammengefügten Hohlkörpern bestehen, die sich berühren, eine Linie bilden und damit - ähnlich den Zinkverdampfern - in unmittelbarer Nähe der von einer Leitwalze getragenen Folie angebracht werden können. Hierzu können den einzelnen Verdampfern ein und nur ein Strahlungsheizkörper zugeordnet werden. Im Rahmen der Erfindung ist es aber auch möglich, mehrere Strahlungsheizkörper, beispielsweise auch Stäbe aus Wolfram, die im Gegensatz zu sinterkeramischen Erzeugnissen mit streng identischen elektrischen Eigenschaften herstellbar sind, parallel oder in Serie geschaltet vorzusehen.

Da die Austrittsöffnung aus dem Verdampfer in beliebiger Richtung angebracht und außerdem die Austrittsöffnung mit einer ebenfalls strahlungsbeheizten Ablenkfläche oder auch Ablenkdüse versehen werden kann, ist es mit Vorteil möglich, die von der Leitwalze getragenen Folie von beliebiger Richtung her zu bedampfen, ohne daß die Folie selbst der Strahlung des Strahlungsheizkörpers ausgesetzt wäre.

Dabei ist es gemäß einer anderen Weiterbildung des Erfindungsgedankens möglich, in einem Aufdampfverfahren mehrere Metalle gleichzeitig gemischt, über die Breite verteilt oder aber auch nacheinander aus mehreren Verdampfern kommend, die um eine Leitwalze angeordnet sind, aufzubringen, um beispielsweise Sandwichschichten aus Metall - Glas - Metall für die Verpackungsindustrie herzustellen.

Dem Verfahren nach der Erfindung geht die Beobachtung und Erkenntnis voraus, daß die durch Dämpfe von Aluminium und anderen verflüssigten reaktiven Metallen im allgemeinen stark angegriffenen Strahlungsheizkörper nicht mehr merkbar angegriffen werden, wenn die Temperatur des Strahlungsheizkörpers gemäß dem Vorschlag nach der Erfindung auf eine Temperatur erhöht wird, die keine Legierungsbildung mit den sonst stark reaktiven Dämpfen mehr zuläßt.

Darüberhinaus kann der im Verdampfer herrschende hohe Dampfdruck eines selbst reaktiven Aufdampfgutes die aufgrund der bekannten Langmuir'schen Gleichung, welche die Aufdampfraten der Metalle im Vakuum betrifft, berechnete Aufdampfrate der Strahlungsheizkörper so weit verringern, daß diese nur noch nach mehreren hundert Stunden Standzeit erneuert werden müssen.

Bei Verwendung eines Strahlungsheizkörpers aus Wolfram, welcher das verflüssigte Metall nicht berührt, soll aufgrund dieser Erkenntnis die Temperatur mindestens 2000°C, vorzugsweise aber mindestens 2500°C betragen. Bei so hohen Temperaturen sind Legierungen von Al, Co, Fe, Ni usw. mit Wolfram nicht mehr beständig. Sie können sich deshalb im Vakuum nicht mehr bilden, falls die reaktiven Metalle in Dampfform mit dem heißen Wolfram in Berührung kommen. Dadurch eröffnet sich die Möglichkeit, das Bandbedampfen anstelle der erfolglos versuchten Laser-Kanonen und anderen mit Spiegeln und Reflektoren arbeitenden, ebenfalls Photone erzeugenden Systemen, die stets zugedampft und deshalb ausgeschaltet werden, mit einem einfachen, weder korrodierenden noch zudampfbaren System, welches auch keine Individualregelung einzelner Verdampfer bedarf, zu lösen. Dadurch ergeben sich sämtliche Vorteile, die bisher nur den Zinkverdampfern eigen waren. Zusätzlich verleihen die auf hohe Temperaturen erhitzten Strahlungsheizkörper, die gleichzeitig zur im Inneren des Hohlkörpers erfolgenden Isolierung des Dampfes beigezogen werden können, den angestrebten höheren Energieinhalt. Während nämlich der aus der Vertiefung eines widerstandbeheizten sinterkeramischen Verdampfers heraustretende Dampf nur eine kinetische Energie von höchstens 0,15 eV besitzt, die durch die unvermeidliche isentrope Expansion des Dampfes auf nur einige Hundertstel eV sinkt bevor es auf die Folie aufkondensieren kann, gestattet das Verfahren nach der Erfindung dank der hohen Strahlungsheizkörpertemperatur und der Isolierung eine Energiesteigerung auf 1 eV und mehr, und kann durch das Bündeln des bereits in der Verdampfkammer iosnisierten und deshalb als gebündelter Strahl heraustretenden Dampfes keine wesentliche Verluste durch isentrope Expansion erleiden.

Das Verwenden eines auf hohe Temperaturen erhitzten Strahlungsheizkörpers innerhalb des diesen nicht berührenden, flüssigen Aufdampfgutes gestattet ein leichtes Ionisieren eines Teiles der verdampfenden Atome oder Moleküle, da bei so hohen Temperaturen dem Strahlungsheizkörper durch Anprall oder durch ein noch im Hohlkörper angelegtes elektrisches Feld Elektronen entzogen und diese einem durch atomare Elektronenaffinität gekennzeichneten Metalldampf angelagert oder aber der Dampf durch Elektronenstoß positiv ionisiert werden kann. Ein erheblicher Vorteil des neuen Bedampfungsverfahrens ist das Ionisieren innerhalb des Hohlkörpers, so daß die reichlich in einer Bedampfungsanlage vorhandenen Restgase und Dämpfe nicht mitionisiert und deshalb weder in die aufkondensierte Schicht eingebaut, noch das elektronische Messen der Schichtstärke stören können. Wird nämlich die Schichtstärke aufgrund der Ionenentladung gemessen und/oder kontrolliert, so können keine fremden Gase oder Dämpfe durch Entladung ihrer Ionen die Messung oder Kontrolle stören. Bei einer geringen Entfernung zwischen Verdampfer und Folie genügen Spannungen weit unterhalb 1 kV, um den teilweise ionisierten Dampf so haftfest und dicht an der Folie zu kondensieren, wie es bisher nur mit Hilfe der aufwendigen Verfahren Kathodenzerstäubung oder Elektrodenstrahlverdampfen und ion plating möglich war.

Ein wichtiges Merkmal des neuen Verfahrens besteht in der Möglichkeit, hoch reflektierende Metalle, die in einer Bandbedampfungsanlge aufgedampft werden sollen, zuerst durch Kontaktwärme, d.h. durch Kontakt mit dem durch Strahlungswärme erhitzen Hohlkörpers, auf jene Temperatur zu bringen, bei welcher ihre bei Zimmertemperatur noch sehr geringe Strahlungsabsorption eines beispielsweise auf 2500°C oder mehr erwärmten Wolframstrahlers auf das zehnfache oder mindestens mehrfache gesteigert wird. Dementsprechend soll die Innenseite des Hohlkörpers oder eine die Innenseite bedeckende Schicht aus einem Material bestehen, welches die Wärmestrahlung gut absorbiert und vorzugsweise die Wärme auch gut leitet. Um die Emissivität der Innenseite auch nach Anschmelzen und Verteilen des noch mäßig strahlungsabsobierenden Metalls zu nützen, kann die Innenseite des Hohkkörpers aus Kapillaren bestehen, deren Durchmesser sich in richtung des Strahlungsheizköpers stufenlos oder stufenweise erweitert, so daß die äußerste Schicht der Innenseite aufgrund des Jurin'schen Gesetzes nur bei dem Erreichen der erwünschten Temperatur weitgehend oder sogar vollständig von dem flüssigen Metall benetzt und zum Hauptabsorbenten der Wärmestrahlung wird.

Ein weiteres Merkmal ist die neue Methode, das Kriechen von insbesondere flüssigem Aluminium auf Teilen, die frei gehalten werden sollen, zu vermeiden. Bekanntlich können sinterkeramische, induktiv beheizte Tiegel auf die Weise von einem Herauskriechen des flüssigen Aluminiums dadurch bewahrt werden, daß der oberste Teil des Tiegels verjüngt und das hochkriechende Aluminium durch direkte Induktionserwärmung verdampft wird, bevor es aus dem Tiegel herauskriechen kann; eine solche Lösung wird beispielsweise auf Abb.4.24 des Buches "Deposition Technologies for films and Coatings", Verfasser R.F. Bunshah et alia, Noyes Publications 1982, dargestellt. Da aber das neue Verfahren thermisch erzeugte Photonen zum Verdampfen des Metalls benützt, wird das unerwünschte Kriechen mit Hilfe einer benetzungsabweisenden Behandlung, beispielsweise durch Beschichten mit pyrolitischem Bornitrid usw. verhindert. Auch kann die Benetzung der inneren Oberfläche eines Hohlköpers auf die Weise unterstützt werden, daß diese den Boden unter einem kleinen Winkel berührt, der die Benetzung fördert, während der große äußere Winkel des Hohlkörpers die Benetzung verhindert. Die zu benetzende Höhe eines Hohlköpers kann auch dadurch bestimmt werden, daß an der gewünschten Benetzungsgrenze ein Übergang von feinen, gut benetzten Kapillaren zu groben oder aus anderen Gründen unbenetzbaren Kapillaren, oder zu einer dichten, bzw. kapillararmen Oberfläche durch sintertechnische, chemische, mechanische usw. Mittel geschaffen wird. Unterhalb der vom verflüssigten Aufdampfgut zu benetzenden Grenze kann die Kapillarität aber nicht nur - wie weiter oben beschrieben - in waagrechter, sondern auch in senkrechter Richtung variieren; so können beispielsweise die an der untersten Stufe noch groben, aber infolge der geringen Höhe noch gut vom verflüssigten Aufdampfgut benetzten Kapillaren mit steigender Höhe in stets feinere Kapillaren übergehen, damit eine auch das Poiseuille' sche Gesetz befriediegende Zufuhr nicht bereits vor Erreichen dieser Grenze leergedampft werden. Zusammenfassend sieht also die Erfindung die Möglichkeit vor, die chemische und/oder physikalische Beschaffenheit der Oberfläche und der unterhalb der Oberfläche liegenden Schichten des Hohlköpers stufenlos oder in Stufen, auch mit scharfen Grenzen, zu verändern, um auf diese Weise die Absorption der thermisch im Inneren des Hohlköpers erzeugten Photonen eines Strahlungsheizkörpers, und/oder die vom verflüssigten Metall zu benetzende oder nicht zu benetzende Oberfläche und/oder die Zufuhr des flüssigen Metalls, usw. zu bestimmen. Ebenfalls sieht die Erfindung die Möglichkeit vor, abgenutze, verstopfte oder sonstwie veränderte Kapillaren durch Aufbringen neuer Schichten oder sonstige physikalische oder chemische Nachbearbeitung zu erneuern und bereits bei der Herstellung des Hohlkörpers solche Kapillaren zu schaffen, die aus einer ursprünglichen schlecht benetzbaren Hohlköperoberfläche durch Ablagerung von im Aufdampfgut gelösten oder erst während des Betriebes, beispielsweise durch Korrosion des Hohlkörpers entstandenen Produkte in gut benetzbare Kapillaren umgewandelt werden.

Die Erfindung soll im folgenden an Beispielen in Verbindung mit der anliegenden Zeichnung, die schematisch Ausführungsformen zeigt, erläutert werden.

Beispiel 1.

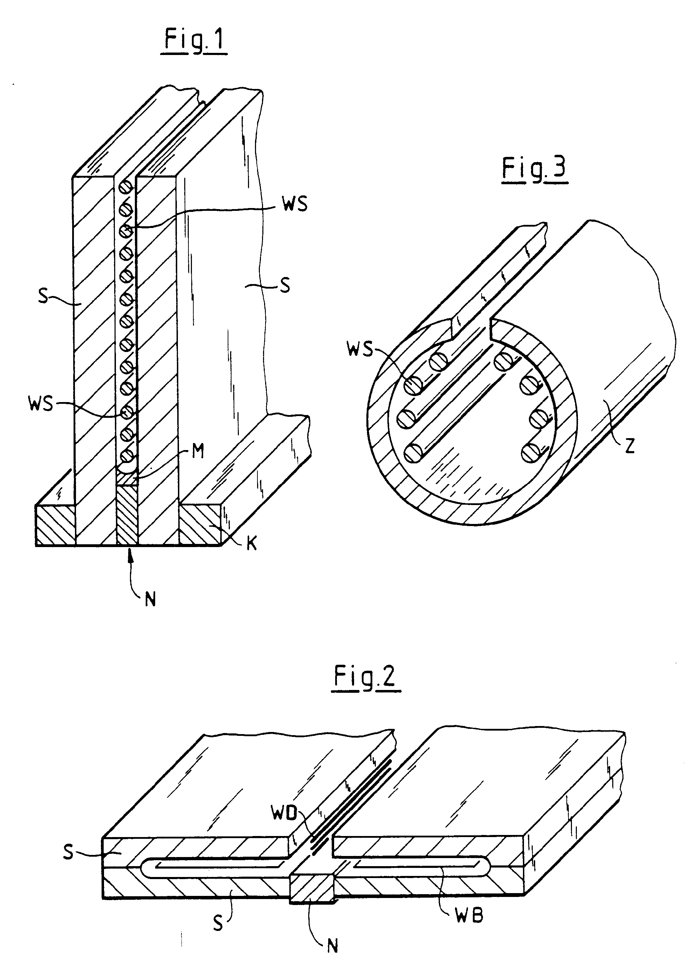

Fig. 1 zeigt schematisch und im Queschnitt eine isometrische Darstellung eines neuen Verdampfers, der aus einem hochschmelzenden Sinterprodukt, beispielsweise aus einem feinporigen Verdampfermaterial in Plattenform hergestellt wird, zusammengefügt ist und mit einem Strahlungsheizkörper aus Wolframstäben ausgestattet wurde. Die Platten S werden mit Hilfe der Klemmbacken K festgehalten. Das Zwischenstück N aus demselben Verdampfermaterial oder aus Aluminiumnitrid, Bornitrid usw. bestimmt die Breite des von den Platten S gebildeten Spalts und soll vorzugsweise nur wenige mm breiter sein, als der Strahlungsheizkörper. In dem so geformten Hohlkörper wird ein Strahlungsheizkörper, bestehend aus den Wolframstäben WS so eingespannt, daß er weder in kaltem noch in heißem Zustand das verflüssigte und auf der Innenseite der Platten S durch Kapillarwirkung hochsteigende oder durch Schwere herunterfließende Metall M berühren kann. Das von den Innenseiten der Platten S verdampfende Metall prallt in Dampfform auf die Wolframstäbe WS auf und entreißt ELektronen, die sich beispielsweise an den elektronegativen Aluminiumdampf anlagern können. Die so gebildeten negativen Ionen können nur teilweise wieder an der Innenwand des Hohlkörpers entladen werden, denn der Dampfdruck des von den Innenseiten der Plattten S abdampfenden Metalls, welches von den auf vorzugsweise mindestens 2500°C erhitzten Strahlungsheizkörpers nicht nur verdampft, sondern auch auf einen Energiegehalt von mindestens 0,25 eV durch Aufprall gebracht wird, reißt den zum Teil ionisierten Metalldampf in Richtung der oben befindlichen Öffnung des Hohlköpers. Nach Verlassen des engen Hohlköpers tritt der Dampf, der auch durch das Strömen in dieselbe Richtung von Ionen desselben Vorzeichens gebündelt wird, mit einem Energieinhalt auf die nicht angezeigte Folie, der mehrere eV betragen kann, falls zwischen Verdampfer und Folie (Leitwalze) eine entsprechende Beschleunigungsspannung angelegt wird. Das entspricht einem Energieinhalt, der erheblich höher ist, als der bisher mit widerstandsbeheizten Verdampfermaterial erzielbare Energieinhalt, und gestattet das erstemal, mit diesem Verdampfermaterial die in der oben angeführten Veröffentlichung von H. Walter beschriebenen, nur mit viel aufwendigeren Verfahren erzielbaren hohen Energieinhalte zu erreichen.

Die Platten S, die infolge der Strahlungsbeheizung im Vergleich mit widerstandabeheizten Verdampfern eine verhältnismäßig geringe Korrosion aufweisen, können aus nur wenige mm starken Lamellen bestehen. Wichtig ist, daß bei dem Zusammenfügen mehrerer Platten zu einem die ganze Bandbreite bedeckenden Verdampfer die Platten so zusammengefügt werden, daß kein Metall durch die Fugen heraustritt; als Dichtungsmittel kann das schon genannte Bornitrid eingesetzt werden; ebenfalls an Stellen, die vom verflüssigten Metall nicht benetzt werden sollen.

Dem neuen Verdampfer können beliebige Maskenabdeckungen aufgesetzt werden, so daß es erstmalig ermöglicht wird, Kondensatorenfolien mit auch beiderseitig verstärktem Aluminiumrand zur guten Kontaktierung und verminderter Randkorrosion so herzustellen, daß dabei keine Verluste des Aluminiumdampfes entstehen. Da die von der Leitwalze getragene Folie sich in unmittelbarer Nähe der Maskenabdeckung befindet, beträgt die Ausbeute des verdampften Metalls das Mehrfache der bisherigen Ausbeute von etwa 30%. Die erhöhte Wärmebelastung der Folien kann durch die in modernen Bandbedampfungsanlagen üblichen hohen Bandgeschwindigkeiten und Leitwalzen-Kühlsysteme neutralisiert werden. Falls der Metalldampf von der senkrechten in eine andere Richtung abgelenkt werden soll, können den neuen Verdampfer entsprechende, ebenfalls mit einem inneren Strahlungskörper ausgestattete einseitige oder mehrseitige Ablenkdüsen aufgesetzt werden.

Die nicht angezeigte Zuführung des Aufdampfgutes erfolgt vorzugsweise in Drahtform. Der Draht kann in den Hohlkörper von oben, von unten oder auch seitlich durch die Hohlkörperwand eingeführt werden. Auch kann der Hohlkörper anatelle der zwei Platten S aus einem einzigen Stück U-förmig hergestellt, unten mit Löchern versehen und in eine Wanne mit verflüssigtem Aluminium, welches durch Kapillarwirkung bekanntlich hochgezogen werden kann, gestellt werden. Es ist ebenfalls bekannt, geringe Zutaten aus Zr, Ti usw. als Benetzungshilfen und korrosionsverhindernde Substanzen beizugeben.

Ebenfalls nicht angezeigt sind die vorzugsweise angewendeten Strahlungschutzmittel aus beispielsweise C- oder $ZrO_2$-Wolle und Schutzblech, die das Heraustreten der Wärmestrahlung aus dem Hohlkörper auf die Öffnung, durch welche der Dampf den Hohlkörper verläßt, beschränken soll.

Der neue Verdampfer wird durch Widerstanderwärmen der Wolframstäbe WS auf 2500°C oder mehr in Betrieb gesetzt. Das durch Kontakt- und Strahlungswärme verflüssigte und an der Innenseite des Hohlkörpers verteilte Metall wird verdampft, erzeugt die bereits beschriebenen negativen Ionen durch Anprall auf den Strahlungsheizkörper und kann auch positiv ionisiert werden, falls zwischen negativem Strahlungsheizkörper und positiv geschalteter Hohlwand oder Ablenkdüse eine Spannung von einigen zehn Volt angelegt wird. Auch kann ein positives Ionisieren des Dampfes durch Aufrechterhaltung von einer ähnlichen Spannung zwischen benachbarten Wolframstäben WS des Strahlungsheizkörpers nicht aus einer, sondern aus zwei Reihen von Wolframstäben WS gebildet werden.

Die in diesem Beispiel angeführte Anordnung besitzt den Vorteil, daß die Herstellung und Erneuerung der Platten S wenig aufwendig ist, genauso ihre Bearbeitung, um besondere, oben beschriebene Effekte der Kapillarität zu erzielen.

Fig. 2 zeigt einen Verdampfer in einem Aufbau mit durch ein Zwischenstück N getrennten, aus Sinterkörpern S bestehenden zwei Hohlkörpern, jeder versehen mit einem getrennten Strahlungsheizkörper WB aus Wolframblech oder Wolframstäben. Der Strahlungsheizkörper wird von der zu bedampfenden Folie nicht "gesehen", die Wärmebelastung der Folie ist entsprechend geringer. Auch ist die Höhe geringer als im vorangegangenen Beispiel, so daß auch schwerere und nicht so gut benetzende Metalle wie Aluminium aufgedampft werden können. Auch Legierungen aus zwei getrennten Komponenten können aufgedampft werden, falls jede Komponente in einen anderen Hohlkörper gefüttert und das Zwischenstück N vorzugsweise mit einem Belag von pyrolitisch abgeschiedenem Bornitrid oder desgleichen beschichtet wird. Da die beiden Strahlungsheizkörper WB getrennt regelbar sind, können in den beiden Hohlkörpern verschiedene Temperaturen eingestellt werden. Zur Anreicherung des Energiegehalts des Dampfes vor seinem Austritt aus dem neuen Verdampfer können zu seinem Ionisieren die dünnen und dementsprechend die Wärmebelastung der zu bedampfenden Folie nicht wesentlich erhöhenden, als Kathoden geschaltete Wolframdrähte WD eingesetzt werden. Auch in diesem Fall können die Hohlkörper aus getrennten Platten bestehen, damit ihre innere Oberfläche besser bearbeitet und erneuert werden kann.

Fig. 3 schließlich zeigt einen Verdampfer, dessen Hohlkörper aus einem Zylinder Z und sein Strahlungskörper wiederum aus den Wolframstäben WS besteht. Der zum Entweichen des metallischen Dampfes bestimmte Spalt kann sich am oberen Ende, aber auch an einem anderen Teil des Zylinders befinden. Auch diese Form eignet sich gut zur industriellen Fertigung, da sie nicht nur durch Strangpressen eines anschließend gesinterten Pulvers, sondern auch durch Aneinanderfügen einzelner kreisförmiger Lamellen, Wickeln und nachträgliches Borieren oder Karburieren eines metallsichen Drahtes usw. hergestellt werden kann, um nur einige Herstellungsmethoden zu nennen.

Durch Drehen des Zylinder Z kann der Dampf in beliebige Richtung gestrahlt werden.

die angeführten Beispiele beschreiben einige der vielen Verfahren und Möglichkeiten, die es gestatten, in einem Bandbedampfungsverfahren, mit thermisch erzeugten Photonen, die mit Hilfe eines in einem Hohlkörper untergebrachten, diesen und das darin durch Einwirkung der Photonen verflüssigte reaktive Metall Al, Co, Fe, Ni nicht berührenden Strahlungsheizkörpers erzeugt worden sind, das reaktive Metall so zum Verdampfen zu bringen, daß der Strahlungsheizkörper von den als sehr reaktiv bezeichneten und ihn umspülenden Dämpfen nicht angegriffen, der Energiegehalt des Dampfes erhöht und durch isentrope Expansion nicht wesentlich geschwächt, der Dampf eine beliebige Maskenabdeckung durchströmend mit einer im Vergleich mit widerstandsbeheizten Verdampfern erheblich gesteigerten Ausbeute auf die Folie aufkondensiert.

Es liegt im Sinne der Erfindung, den Hohlkörper aus jedem beliebigen Material, welches vom verflüssigten reaktiven Metall nicht oder nur mäßig angegriffen wird, in beliebiger Hohlkörperform herzustellen und das Material und die Form der Strahlungsheizkörper anders als in den Beispielen beschrieben zu bestimmen.

Weiterhin sieht die Erfindung die Möglichkeit vor, nicht nur dem Träger des Aufdampfgutes, sondern auch dem Strahlungsheizkörper die Gestalt eines Hohlkörpers zu verleihen. Werden beispielsweise Strahlungsheizkörper eingesetzt, deren Querschnitt etwa einem "U" entspricht und wird die Öffnung eines so geformten Hohlkörpers auf das Aufdampfgut gerichtet, so ist die Strahlung aus dem Inneren dieses hohlkörperförmigen Strahlungsheizkörpers bekanntlich immer intensiver als die Strahlung der Außenwand desselben Strahlungsheizkörpers. Obwohl die Herstellung hohlkörperförmiger Strahlungsheizkörper allgemein aufwendiger ist als diejenige der flachen Bleche, Stäbe einfachen oder verdrillten Drähte oder Spulen gestatten sie den Aufbau besonders einfacher und gedrungener (kompakter) neuer Vorrichtungen. So können, um nur ein einziges Beispiel zu nennen, die in Fig.1 schematische dargestellten Heizstäbe WS durch einen einzigen U-förmigen, mit der Öffnung nach unten gerichteten, aus W, Ta, usw. hergestellten Hohlkörper bestehen. Eine solche Anordnung bringt den Vorteil, daß die Strahlung in Richtung der zu bedampfenden Folie geringer ist als in Richtung des im unteren Teil des bestrahlten Hohlkörpers befindlichen Aufdampfgutes. Auch kann dadurch die Größe des bestrahlten Hohlkörpers verringert werden. Es können nicht nur mehrere Stäbe oder Bleche aus W, Ta, usw., sondern auch solche aus diesen geformten Hohlkörper parallel angeordnet und als gleichzeitiger Strahlungsheizkörper und Dampf-Ionisierer verwendet werden.

## Patentansprüche

1. Verfahren zum Metallisieren von Folienoberflächen mit einem reaktiven Material, wie Al, Co, Fe, Ni, in einer Bandbedampfungsanlage, in der die zu bedampfende Folie in Vakuum über einen gegebenenfalls aus mehreren Einzelverdampfern bestehenden Verdampfer aus einem hochschmelzenden, insbesondere gesinterten und zumindest in seiner Oberfläche porösen beziehungsweise mit Kapillaren versehenen Material geführt wird, wobei der Oberfläche des Verdampfers das zu verdampfende Material in seiner Flüssigphase zugeführt und dort weiterer Wärmezufuhr ausgesetzt wird, und bei dem das verflüssigte zu verdampfende Material auf der Innenseite eines mit einer Austrittsöffnung versehenen Hohlkörpers geführt und dort der Strahlung thermisch erzeugter Photonen eines das verflüssigte Metall nicht berührenden Strahlungsheizkörpers ausgesetzt wird.

2. Verfahren nach Anspruch 1, dadurch gekennzeichnet, daß ein Verdampfer mit einer schlitzförmigen Austrittsöffnung verwendet wird.

3. Verfahren nach Anspruch 1, dadurch gekennzeichnet, daß der Strahlungsheizkörper mit einer Oberflächentemperatur von mindestens 2000°C betrieben wird.

4. Verdampfer zur Verwendung in einer Vakuumbandbedampfungsanlage zum Metallisieren von Folien mit reaktiven Metall, wie Al, Co, Fe, Ni, in Form eines in Aufdampfrichtung offenen Hohlkörpers zur Aufnahme des zu verdampfenden Metalls in seiner Flüssigphase, in dessen Inneren ein das flüssige Metall nicht berührender Strahlungsheizkörper für eine weitere Wärmezufuhr zu dem verflüssigten, zu verdampfenden Metall vorgesehen ist, dadurch gekennzeichnet, daß mindestens ein Teil der Wandungen des Verdampfers aus einem hochschmelzenden, zumindest in seiner Oberfläche porösen oder mit Kapillaren versehenen Material besteht.

5. Verdampfer nach Anspruch 4, dadurch gekennzeichnet, daß Kapillaren oder Kanäle vorgesehen sind, die im Inneren der Verdampferwandung einen größeren Durchmesser aufweisen als auf der Innenwandung des Verdampfers.

6. Verdampfer nach Anspruch 4, dadurch gekennzeichnet, daß der Strahlungsheizkörper mit einer Abdeckvorrichtung zur Verhütung des direkten Bestrahlens der zu Bedampfenden Folie versehen ist.

7. Verdampfer nach Anspruch 4, dadurch gekennzeichnet, daß als Bestrahlungsheizkörper ein Hohlkörper vorgesehen ist, der zumindest einen Austrittsschlitz für im Inneren abgegebene Strahlung aufweist, der gegen den zu erhitzenden Bereich im Verdampfer gerichtet ist.

8. Verdampfer nach Anspruch 4, dadurch gekennzeichnet, daß dieser als eine Düse zur Erzeugung eines Richtstrahles ausgebildet ist.

## Claims

1. A process of metallising foils with reactive metals such as Al, Co, Fe, Ni, in which the moving foil to be metallised faces one or more evaporators consisting of refractory and preferably sintered material with at least surface porosity or surface capillaries, the evaporant being melted and fed to the evaporator surface where said liquid evaporant receives further heat energy, **characterized in that** said liquid evaporant is directed to the inner side of a cavity or hollow body having a vapour dispensing opening, and there exposed to photons thermally generated by a radiation heater that does not touch said liquid evaporant.

2. A process according to Claim 1, characterized in that an evaporator is employed with an opening shaped as a slit.

3. A process according to Claim 1, characterized in that the surface temperature of the radiation heater is at least 2000°C.

4. An evaporator for evaporating molten reactive metals such as Al, Co, Fe, Ni in a vacuum roll coating plant, said evaporator shaped as a cavity or hollow body that holds the liquid metallic evaporant and has a directional opening for releasing the vapour produced, said evaporator also comprising within said cavity a radiation heater that does not touch the liquid evaporant, **characterized in that** at least sections of the cavity wall or walls are made of a refractory material with at least surface porosity or capillarity.

5. An evaporator according to Claim 4, **characterized in that** the capillaries or channels have larger diameters or cross sections within the walls of said evaporator than on the inner side of said walls.

6. An evaporator according to Claim 4, **characterized in that** the radiation heater is covered in order to prevent exposure of the foils being metallised, to the photons directly radiated by said radiation heater.

7. An evaporator according to Claim 4, **characterized in that** the radiation heater is shaped as a hollow body comprising at least one opening for releasing and directing the radiated energy generated within said hollow body, to domains to be heated in said evaporator.

8. An evaporator according to Claim 4, **characterized in that** the evaporator comprises a vapour beam shaping funnel or nozzle.

**Revendications**

1. Un procédé de métallisation en continu et sous vide de feuilles et rubans exposés aux vapeurs de métaux réactifs tels que l'Al, le Co, le Fe, le Ni évaporés à partir d'un évaporateur composé ou non de plusieurs évaporateurs individuels, ledit évaporateur fait en matériaux réfractaires de préférence frittés et ayant au moins sur sa surface des pores ou capillaires, lesdits métaux réactifs étant liquifiés et dirigés vers la surface dudit évaporateur où ils reçoivent une dose supplémentaire de chaleur, le procédé **caractérisé par ce que** lesdits métaux liquifiés sont dirigés vers la surface intérieure des parois d'une cavité ayant une ouverture et exposés dans ladite cavité aux photons d'origine thermique produits par un radiateur de chaleur, sans que ce dernier touche lesdits métaux réactifs liquides.

2. Un procédé correspondant à la revendication sous 1°, **caractérisé par ce que** l'ouverture de la cavité a la forme d'une fente.

3. Un procédé correspondant à la revendication sous 1°, **caractérisé par ce que** la température du radiateur est d'au moins 2000°C.

4. Un évaporateur destiné à la métallisation de feuilles et rubans en continu et sous vide avec des métaux réactifs tels que l'Al, le Co, le Fe, le Ni, ledit évaporateur ayant la forme d'une cavité pourvue d'une ouverture pour faire sortir dans une direction choisie les vapeurs produites à son intérieur, ladite cavité destinée à la réception de métaux réactifs liquides et contenant à son intérieur un radiateur de chaleur pour augmenter la température desdits métaux réactifs liquides sans toutefois toucher ces derniers, ledit évaporateur **caractérisé par ce qu'**au moins une partie de ses parois consiste en matière réfractaire dont au moins la surface est poreuse ou capillaire.

5. Un évaporateur correspondant à la revendication 4°, **caractérisé par ce qu'**il contient des capillaires ou conduits dont la section ou le diamètre est plus grand à l'intérieure des parois de la cavité qu'à la surface intérieure de cette dernière.

6. Un évaporateur correspondant à la revendication 4°, **caractérisé par ce que** le radiateur de chaleur porte une couverture ou un écran pour diminuer son rayonnement thermique sur la feuille ou le ruban à métalliser.

7. Un évaporateur correspondant à la revendication 4°, **caractérisé par ce que** le radiateur de chaleur a la forme d'une cavité ayant au moins une ouverture pour diriger la chaleur produite à son intérieur, vers la partie à chauffer de l'évaporateur.

8. Un évaporateur correspondant à la revendication 4°, **caractérisé par ce qu'**il comprend une tuyère susceptible de produire un jet dirigé de vapeur.

## Fig.1

WS

S

S

WS

M

K

N

## Fig.3

WS

Z

## Fig.2

WD

S

S

N

WB